# EUROPEAN PATENT APPLICATION

(11) **EP 3 860 309 A1**
(43) Date of publication of application: **04.08.2021**
(21) Application number: 19864956.8
(22) Date of filing: 24.09.2019
(51) Int. Cl.: H05B 33/10, B05D 1/26, B05D 3/12, B05D 7/00, H01L 51/50, H05B 33/22

(54) **METHOD FOR MANUFACTURING SUBSTRATE WITH ATTACHED ORGANIC FUNCTIONAL FILM**

(30) Priority: 25.09.2018 JP 2018179020
(71) Applicant: Nissan Chemical Corporation, Tokyo 103-6119 (JP)
(72) Inventor: SHIBATA Chika, Funabashi-shi, Chiba 274-0052 (JP)
(74) Representative: Mewburn Ellis LLP
(86) International application number: PCT/JP2019/037192
(87) International publication number: WO 2020/066979

(57) **Abstract**

Provided is a method for manufacturing an electronic device having a substrate, partition walls which define openings on the substrate, and an organic functional film inside the partition walls, the method comprising: a step in which an organic functional ink containing an organic functional material component and a triethylene glycol-containing solvent is applied on the inside of the partition walls by an inkjet method; and a step for forming an organic functional film by removing the solvent under reduced pressure from the organic functional ink applied on the inside of the partition walls, wherein the content of triethylene glycol in the solvent is 3-17 mass%. Accordingly, an electronic device having an organic functional film which has a uniform thickness and in which the occurrence of crawl up is suppressed can be obtained.

## Description

### TECHNICAL FIELD

The present invention relates to a method for manufacturing a substrate having an organic functional film thereon.

### BACKGROUND ART

Organic functional films made of organic compounds are used as light-emitting layers and charge-injecting layers in organic electroluminescent (organic EL) devices. In particular, a hole-injecting layer is responsible for transferring charge between an anode and a hole-transporting layer or a light-emitting layer, and thus serves an important function in achieving low-voltage driving and high brightness in organic EL devices.

Processes for forming hole-injecting layers are broadly divided into dry processes such as vapor deposition and wet processes such as spin coating. On comparing these types of processes, wet processes are better able to efficiently produce thin films of high flatness over a large surface area. Hence, with the development today of organic EL displays of increasingly large surface area, there exists a desire for hole-injecting layers that can be formed by wet processes. Art relating to hole-injecting layers that can be formed by wet processes has been reported in the literature (see, for example, Patent Document 1).

In the manufacture of an organic EL display, when a hole-injecting layer or other organic functional layer is formed by a wet process, a bank is generally provided so as to surround the layer-forming region, and an organic functional ink is applied within the opening in this bank.

At this time, a "pile-up" effect sometimes arises; that is, ink that has been applied within the opening may pile up the sides of the bank, making the peripheral edge of the applied film in contact with the sides of the bank thicker than the center portion of the film.

This pile-up effect gives rise to a state in which the stacking sequence of the plurality of organic functional layers that have been formed between the electrodes does not conform with the design, and a leakage current path forms. As a result, the desired device characteristics cannot be achieved. Also, the hole-injecting layer or other organic function layer that has piled up may give rise to non-uniform light emission by the resulting organic EL device.

Means for suppressing the pile-up effect are described in Patent Documents 2 and 3. Given the circumstances lately where development on organic EL displays manufactured using wet processes is proceeding apace, the desire for art relating to the suppression of such a pile-up effect has become even more acute.

### PRIOR ART DOCUMENTS

### PATENT DOCUMENTS

Patent Document 1: WO 2008/032616
Patent Document 2: JP-A 2009-104859
Patent Document 3: JP-A 2011-103222

### SUMMARY OF INVENTION

### TECHNICAL PROBLEM

It is therefore an object of the invention to provide a method for manufacturing a substrate having an organic functional film of uniform thickness thereon by suppressing the pile-up effect.

### SOLUTION TO PROBLEM

The inventors have conducted extensive investigations in order to achieve the above object. As a result, they have discovered that by using a triethylene glycol-containing solvent as the solvent for an organic functional ink, when the ink is applied within a bank by an inkjet process, a thin film in which ink pile-up has been minimized can be formed.

Accordingly, the invention provides:
1. A method for manufacturing a substrate with organic functional film having a substrate, a bank that defines an opening on the substrate and an organic functional film within the bank, which method includes the steps of applying an organic functional ink that includes an organic functional material and a triethylene glycol-containing solvent within the bank by an inkjet process, and removing the solvent from the organic functional ink applied within the bank by applying a vacuum and thus forming an organic function film, wherein the content of triethylene glycol in the solvent is from 3 to 17 wt%;
2. The method for manufacturing a substrate with organic functional film of 1 above which further includes, following removal of the solvent component by applying a vacuum, the step of heating;
3. The method for manufacturing a substrate with organic functional film of 1 or 2 above, wherein the solvent includes a glycol solvent having a lower boiling point than triethylene glycol;
4. The method for manufacturing a substrate with organic functional film of any of 1 to 3 above, wherein the solvent includes a glycol ether solvent having a lower boiling point than triethylene glycol;
5. The method for manufacturing a substrate with organic functional film of any of 1 to 4 above, wherein the solvent includes triethylene glycol, diethylene glycol and triethylene glycol dimethyl ether;
6. The method for manufacturing a substrate with organic functional film of any of 1 to 5 above, wherein the organic functional material is an aniline derivative;
7. A method for manufacturing an electronic device, which method includes the step of forming an organic functional layer on the substrate with organic functional film obtained by the method of any of 1 to 6 above;
8. A pile-up suppressing method which, in the manufacture of a substrate with organic functional film having a substrate, a bank that defines an opening on the substrate and an organic functional film within the bank, suppresses a pile-up effect in the bank by an organic functional ink containing an organic functional material and a solvent when the ink is applied within the bank by an inkjet process, which method containing using as the organic functional ink a solvent having a triethylene glycol content of from 3 to 17 wt%; and
9. An inkjet ink that, during the manufacture of a substrate with organic functional film having a substrate, a bank that defines an opening on the substrate and an organic functional film within the bank, is applied within the bank by an inkjet process, which ink includes an organic functional material and a triethylene glycol-containing solvent, the content of triethylene glycol in the solvent being from 3 to 17 wt%.

### ADVANTAGEOUS EFFECTS OF INVENTION

The inventive method for manufacturing a substrate with organic functional film suppresses ink pile-up within a bank on the substrate, enabling a substrate having an organic functional film of uniform film thickness thereon to be efficiently produced.

### BRIEF DESCRIPTION OF DIAGRAMS

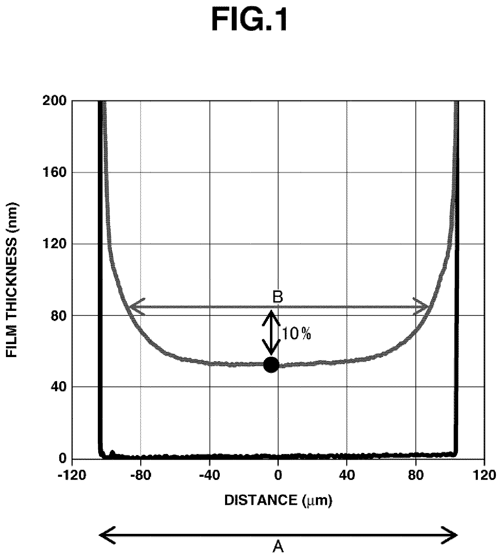

[FIG. 1] FIG. 1 is an explanatory diagram of the method for computing the pile-up index in an embodiment of the invention.

### DESCRIPTION OF EMBODIMENTS

The invention is described below in greater detail. In this invention, the term 'solids' in connection with the organic functional ink refers to constituents other than the solvent that are included in the ink. Also, "charge transportability" is synonymous with electrical conductivity, and is also synonymous with hole transportability.

The inventive method for manufacturing a substrate with organic functional film is a method for manufacturing a substrate with organic function film that has a substrate, a bank that defines an opening on the substrate and an organic functional film within the bank, which method is characterized by including the step of applying an organic functional ink that includes an organic functional material and a triethylene glycol-containing solvent within the bank by an inkjet process, and the step of removing the solvent from the organic functional ink applied within the bank by applying a vacuum and thus forming an organic functional film, wherein the content of triethylene glycol in the solvent is from 3 to 17 wt%.

This invention is characterized by using, as the organic functional ink solvent (also referred to below as the "ink solvent"), a solvent having a triethylene glycol content of from 3 to 17 wt%. By using this solvent, the pile-up effect by the ink applied within the bank can be effectively suppressed, making the thickness of the thin film created more uniform. From the standpoint of reproducibly obtaining a substrate with organic functional film wherein the pile-up effect has been suppressed and which has an organic functional film of uniform thickness, the triethylene glycol content is preferably from 4 to 16 wt%, and more preferably from 5 to 15 wt%.

The ink solvent used in the invention is not particularly limited, provided that the triethylene glycol content is from 3 to 17 wt%. The balance (83 to 97 wt%) of the solvent ingredients used may be suitably selected from among solvents that have hitherto been used in organic functional inks. However, to further increase the pile-up suppressing effect, the balance of the solvent ingredients are preferably solvents having, under atmospheric pressure (1.013× 10⁵ Pa), boiling points that are lower, more preferably solvents having boiling points that are at least 10°C lower, even more preferably solvents having boiling points that are at least 20°C lower, and still more preferably solvents having boiling points that are at least 30°C lower, than triethylene glycol (boiling point, 287°C).

It is preferable for another glycol solvent having a lower boiling point than triethylene glycol to be included in the ink solvent used in the invention.

Specific examples of such other glycol solvents include ethylene glycol (boiling point, 197°C), propylene glycol (boiling point, 188°C), diethylene glycol (boiling point, 244°C), dipropylene glycol (boiling point, 232°C), tripropylene glycol (boiling point, 273°C), hexylene glycol (boiling point, 197°C), 1,2-butanediol (boiling point, 193°C), 2,3-butanediol (boiling point, 182°C), 1,3-butanediol (boiling point, 207°C), 1,4-butanediol (boiling point, 228°C) and 1,5-pentanediol (boiling point, 239°C). These may be used singly, or two or more may be used in combination.

The total proportion of such other glycol solvents in the ink solvent should be 97 wt% or less. However, from the standpoint of reproducibly obtaining a substrate with organic functional film in which the pile-up effect is suppressed and which has an organic functional film of uniform thickness, the total proportion is preferably from 5 to 80 wt%, more preferably from 10 to 70 wt%, even more preferably from 15 to 60 wt%, and still more preferably from 20 to 50 wt% (provided that the sum of all the solvents used is 100 wt%).

In addition, the ink solvent used in the invention preferably includes a glycol ether solvent having a lower boiling point than triethylene glycol.

Specific examples of such glycol ether solvents include glycol monoether solvents such as ethylene glycol monopropyl ether (boiling point, 151°C), ethylene glycol monohexyl ether (boiling point, 208°C), propylene glycol monobutyl ether (boiling point, 170°C), diethylene glycol monoethyl ether (boiling point, 196°C), dipropylene glycol monobutyl ether (boiling point, 229°C), ethylene glycol monobutyl ether (boiling point, 171°C), diethylene glycol monobutyl ether (boiling point, 230°C), diethylene glycol monoisobutyl ether (boiling point, 160°C), dipropylene glycol monomethyl ether (boiling point, 188°C), propylene glycol monopropyl ether (boiling point, 149°C), diethylene glycol monopropyl ether (propyl carbitol), diethylene glycol monohexyl ether (hexyl carbitol), 2-ethylhexyl carbitol (boiling point, 272°C), dipropylene glycol monopropyl ether (boiling point, 210°C), tripropylene glycol monomethyl ether (boiling point, 243°C), diethylene glycol monomethyl ether (boiling point, 193°C), tripropylene glycol monobutyl ether (boiling point, 274°C) and 2-phenoxyethanol (boiling point, 245°C); and glycol diether solvents such as ethylene glycol dimethyl ether (boiling point, 84°C), ethylene glycol diethyl ether (boiling point, 121°C), ethylene glycol dibutyl ether (boiling point, 202°C), diethylene glycol dimethyl ether (boiling point, 162°C), diethylene glycol diethyl ether (boiling point, 188°C), propylene glycol dimethyl ether (boiling point, 97°C), propylene glycol diethyl ether (boiling point, 124°C), propylene glycol dibutyl ether, dipropylene glycol methyl n-propyl ether (boiling point, 203°C), dipropylene glycol dimethyl ether (boiling point, 175°C), dipropylene glycol diethyl ether (boiling point, 221°C), dipropylene glycol dibutyl ether (boiling point, 296°C), triethylene glycol dimethyl ether (boiling point, 216°C), triethylene glycol butyl methyl ether (boiling point, 261°C) and tetraethylene glycol dimethyl ether (boiling point, 276°C). These may each be used singly, or two or more may be used in combination.

The total proportion of glycol ether solvents in the ink solvent should be 97 wt% or less. However, from the standpoint of reproducibly obtaining a substrate with organic functional film in which the pile-up effect is suppressed and which has an organic functional film of uniform thickness, the total proportion is preferably from 20 to 90 wt%, more preferably from 30 to 85 wt%, and even more preferably from 40 to 80 wt% (provided that the sum of all the solvents used is 100 wt%).

When three ingredients are used--triethylene glycol, another glycol solvent and a glycol ether solvent, the contents thereof are preferably 3 to 17 wt% of triethylene glycol, 15 to 60 wt% of another glycol solvent and 30 to 85 wt% of a glycol ether solvent (for a total of 100 wt%); and more preferably 4 to 16 wt% of triethylene glycol, 20 to 50 wt% of another glycol solvent and 40 to 80 wt% of a glycol ether solvent (for a total of 100 wt%). The ratio of triethylene glycol and the other glycol solvent to the glycol ether solvent is preferably such that (combined weight of triethylene glycol and other glycol solvent) : (weight of glycol ether solvent) = 1:1.1 to 1:2.5, and more preferably from 1:1.2 to 1:2.4.

Also, the ratio of triethylene glycol to the other glycol solvent is preferably such that (weight of triethylene glycol) : (weight of other glycol solvent) = 1:1.3 to 1:10.0, and more preferably from 1:1.3 to 1:8.0.

In addition to the above solvents, for such purposes as to adjust the viscosity and the surface tension, the ink solvent used in this invention may include other solvents that have hitherto been used as ink solvents. In this case too, solvents having a lower boiling point than triethylene glycol are preferred.

Specific examples of such other solvents include sulfur-containing solvents such as dimethylsulfoxide and sulfolane; urea solvents such as tetramethylurea and N,N'-dimethylpropyleneurea; amide solvents such as N-methylpyrrolidone, dimethylformamide and dimethylacetamide; halogenated hydrocarbon solvents such as dichloromethane; ester solvents such as ethyl acetate, n-propyl acetate, n-butyl acetate, ethyl benzoate, methyl benzoate, diethyl fumarate and butyl benzoate; carbonate solvents such as dimethyl carbonate, ethylene carbonate and propylene carbonate; nitrile solvents such as acetonitrile, 3-methoxypropionitrile and 3-ethoxypropionitrile; ketone solvents such as acetone, acetonylacetone, methyl ethyl ketone, methyl isobutyl ketone, methyl isobutenyl ketone, 2-hexanone, 2-pentanone, acetophenone, ethyl phenyl ketone, cyclohexanone and cyclopentanone; alcohol solvents such as methanol, ethanol, trifluoroethanol, n-propanol, isopropanol, n-butanol, t-butanol, benzyl alcohol and 2-(benzyloxy)ethanol; ether solvents such as tetrahydrofuran, tetrahydropyran, dioxane, methyl anisole, dimethyl anisole, ethyl anisole, butyl phenyl ether, butyl anisole, pentyl anisole, hexyl anisole, heptyl anisole, octyl anisole and phenoxytoluene; and aromatic hydrocarbon solvents such as toluene, xylene, pentylbenzene, hexylbenzene, heptylbenzene, octylbenzene, nonylbenzene, cyclohexylbenzene and tetralin. These may each be used singly, or two or more may be used in combination.

When such other solvents are used, the total proportion thereof in the ink solvent is typically less than 10 wt%. From the standpoint of reproducibly obtaining a substrate with organic functional film in which the pile-up effect is suppressed and which has an organic functional film of uniform thickness thereon, the total proportion of such other solvents is preferably less than 5 wt% (provided that the sum of all the solvents used is 100 wt%).

Suitable compositions of the ink solvent used in the invention are exemplified by, but not limited to, combinations of triethylene glycol, diethylene glycol and triethylene glycol dimethyl ether, and combinations of triethylene glycol, diethylene glycol, triethylene glycol dimethyl ether and 2-phenoxyethanol.

In this invention, from the standpoint of reproducibly obtaining a substrate with organic functional film in which the pile-up effect is suppressed and which has an organic functional film of uniform thickness thereon, the ink solvent preferably does not include water as a solvent, although this is not to deny the presence of trace amounts of water included in the organic solvents that are used or of water included in the solids.

As mentioned above, this invention is characterized by using an ink solvent having a triethylene glycol content of from 3 to 17 wt%. Hence, the organic functional material, the substrate with banks to which the organic functional material is applied, the inkjet apparatus and the like may be suitably selected and used from among hitherto known materials and equipment.

The organic functional material may be one that has hitherto been used as a functional material in electronic devices. Specific examples include charge-transporting polymers having a weight-average molecular weight of from 5,000 to 30,000 and charge-transporting oligomers. However, to suppress undesirable effects such as precipitation in the ink solvent and thus reproducibly obtain a film of uniform thickness and to increase the charge transportability of the organic functional film, a charge-transporting oligomer is preferred. Here, the "molecular weight" of a polymer refers to its weight-average molecular weight, and "weight-average molecular weight" refers to the polystyrene-equivalent weight-average molecular weight obtained by gel permeation chromatography.

The molecular weight of the charge-transporting oligomer is generally from 200 to 5,000, with the lower limit being preferably at least 300, and more preferably at least 400, and the upper limit being preferably 4,000 or less, more preferably 3,000 or less, and even more preferably 2,000 or less.

A single monodisperse charge-transporting organic compound may be used alone as the charge-transporting oligomer, or two or more differing monodisperse charge-transporting organic compounds may be used in combination. From the standpoint of reproducibly suppressing the pile-up effect, it is preferable to use from one to three monodisperse charge-transporting organic compounds.

In particular, owing to their excellent solubility in organic solvents and their excellent charge transportability, aniline derivatives and thiophene derivatives are preferred, and aniline derivatives are more preferred, as the organic functional material used in the invention.

Exemplary aniline derivatives include those disclosed in, for example, WO 2005/043962 and WO 2013/042623. The aniline derivatives are more specifically exemplified by compounds of formulas (1) and (2) below.

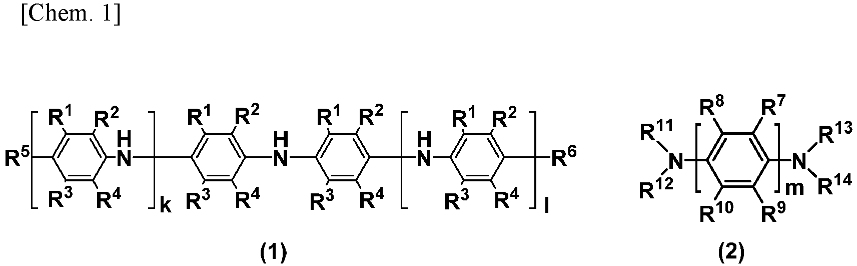

The aniline derivatives of formula (1) may be oxidized aniline derivatives having within the molecule a quinonediimine structure of the following formula (quinonediimine derivative). Methods of oxidizing aniline derivatives to form quinonediimine derivatives include the methods described in WO 2008/010474 and WO 2014/119782.

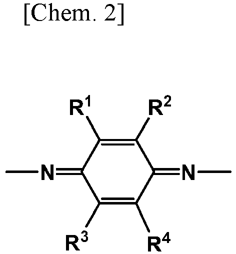

In formula (1), R¹ to R⁶ are each independently a hydrogen atom, a halogen atom, a nitro group, a cyano group, an amino group, an alkyl group of 1 to 20 carbon atoms, alkenyl group of 2 to 20 carbon atoms or alkynyl group of 2 to 20 carbon atoms that may be substituted with Z¹, an aryl group of 6 to 20 carbon atoms or heteroaryl group of 2 to 20 carbon atoms which may be substituted with Z², -NHY¹, -NY²Y³, -OY⁴ or -SY⁵; Y¹ to Y⁵ are each independently an alkyl group of 1 to 20 carbon atoms, alkenyl group of 2 to 20 carbon atoms or alkynyl group of 2 to 20 carbon atoms which may be substituted with Z¹, or an aryl group of 6 to 20 carbon atoms or heteroaryl group of 2 to 20 carbon atoms which may be substituted with Z²; Z¹ is a halogen atom, a nitro group, a cyano group, an amino group, or an aryl group of 6 to 20 carbon atoms or heteroaryl group of 2 to 20 carbon atoms which may be substituted with Z³; Z² is a halogen atom, a nitro group, a cyano group, an amino group, or an alkyl group of 1 to 20 carbon atoms, alkenyl group of 2 to 20 carbon atoms or alkynyl group of 2 to 20 carbon atoms which may be substituted with Z³; Z³ is a halogen atom, a nitro group, a cyano group or an amino group; and the subscripts 'k' and '1' are each independently an integer from 1 to 5.

In formula (2), R⁷ to R¹⁰ are each independently a hydrogen atom, a halogen atom, a nitro group, a cyano group, a hydroxyl group, a thiol group, a phosphoric acid group, a sulfonic acid group, a carboxyl group, an alkoxy group of 1 to 20 carbon atoms, thioalkoxy group of 1 to 20 carbon atoms, alkyl group of 1 to 20 carbon atoms, alkenyl group of 2 to 20 carbon atoms or alkynyl group of 2 to 20 carbon atoms that may be substituted with Z¹, an aryl group of 6 to 20 carbon atoms or aralkyl group of 7 to 20 carbon atoms that may be substituted with Z², or an acyl group of 1 to 20 carbon atoms; R¹¹ to R¹⁴ are each independently a hydrogen atom, phenyl group, naphthyl group, pyridyl group, pyrimidinyl group, pyridazinyl group, pyrazinyl group, furanyl group, pyrrolyl group, pyrazolyl group, imidazolyl group or thienyl group (these groups may be substituted with a halogen atom, a nitro group, a cyano group, a hydroxyl group, a thiol group, a phosphoric acid group, a sulfonic acid group, a carboxyl group, an alkoxy group of 1 to 20 carbon atoms, a thioalkoxy group of 1 to 20 carbon atoms, an alkyl group of 1 to 20 carbon atoms, a haloalkyl group of 1 to 20 carbon atoms, an alkenyl group of 2 to 20 carbon atoms, an alkynyl group of 2 to 20 carbon atoms, an aryl group of 6 to 20 carbon atoms, an aralkyl group of 7 to 20 carbon atoms or an acyl group of 1 to 20 carbon atoms), or a group represented by formula (3) (provided that at least one of R¹¹ to R¹⁴ is a hydrogen atom); and the subscript 'm' is an integer from 2 to 5. Z¹ and Z² are the same as described above.

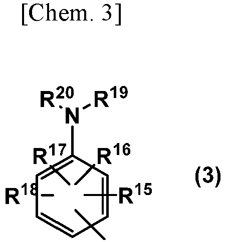

In formula (3), R¹⁵ to R¹⁸ are each independently a hydrogen atom, a halogen atom, a nitro group, a cyano group, a hydroxyl group, a thiol group, a phosphoric acid group, a sulfonic acid group, a carboxyl group, an alkoxy group of 1 to 20 carbon atoms, thioalkoxy group of 1 to 20 carbon atoms, alkyl group of 1 to 20 carbon atoms, alkenyl group of 2 to 20 carbon atoms or alkynyl group of 2 to 20 carbon atoms which may be substituted with Z¹, an aryl group of 6 to 20 carbon atoms or aralkyl group of 7 to 20 carbon atoms which may be substituted with Z², or an acyl group of 1 to 20 carbon atoms; R¹⁹ and R²⁰ are each independently a phenyl group, naphthyl group, anthryl group, pyridyl group, pyrimidinyl group, pyridazinyl group, pyrazinyl group, furanyl group, pyrrolyl group, pyrazolyl group, imidazolyl group or thienyl group (these groups may mutually bond to form a ring, or may be substituted with a halogen atom, a nitro group, a cyano group, a hydroxyl group, a thiol group, a phosphoric acid group, a sulfonic acid group, a carboxyl group, an alkoxy group of 1 to 20 carbon atoms, a thioalkoxy group of 1 to 20 carbon atoms, an alkyl group of 1 to 20 carbon atoms, a haloalkyl group of 1 to 20 carbon atoms, an alkenyl group of 2 to 20 carbon atoms, an alkynyl group of 2 to 20 carbon atoms, an aryl group of 6 to 20 carbon atoms, an aralkyl group of 7 to 20 carbon atoms or an acyl group of 1 to 20 carbon atoms). Z¹ and Z² are the same as described above.

In the above formulas, the halogen atoms are exemplified by fluorine atoms, chlorine atoms, bromine atoms and iodine atoms.

The alkyl groups of 1 to 20 carbon atoms may be linear, branched or cyclic. Illustrative examples include linear or branched alkyl groups of 1 to 20 carbon atoms, such as methyl, ethyl, n-propyl, isopropyl, n-butyl, isobutyl, s-butyl, t-butyl, n-pentyl, n-hexyl, n-heptyl, n-octyl, n-nonyl and n-decyl groups; and cyclic alkyl groups of 3 to 20 carbon atoms, such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, biyclooctyl, bicyclononyl and bicyclodecyl groups.

Specific examples of alkenyl groups of 2 to 20 carbon atoms include ethenyl, n-1-propenyl, n-2-propenyl, 1-methylethenyl, n-1-butenyl, n-2-butenyl, n-3-butenyl, 2-methyl-1-propenyl, 2-methyl-2-propenyl, 1-ethylethenyl, 1-methyl-1-propenyl, 1-methyl-2-propenyl, n-1-pentenyl, n-1-decenyl and n-1-eicosenyl groups.

Specific examples of alkynyl groups of 2 to 20 carbon atoms include ethynyl, n-1-propynyl, n-2-propynyl, n-1-butynyl, n-2-butynyl, n-3-butynyl, 1-methyl-2-propynyl, n-1-pentynyl, n-2-pentynyl, n-3-pentynyl, n-4-pentynyl, 1-methyl-n-butynyl, 2-methyl-n-butynyl, 3-methyl-n-butynyl, 1,1-dimethyl-n-propynyl, n-1-hexynyl, n-1-decynyl, n-1-pentadecynyl and n-1-eicosynyl groups.

Specific examples of aryl groups of 6 to 20 carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl and 9-phenanthryl groups.

Specific examples of aralkyl groups of 7 to 20 carbon atoms include benzyl, phenylethyl, phenylpropyl, naphthylmethyl, naphthylethyl and naphthylpropyl groups.

Specific examples of heteroaryl groups of 2 to 20 carbon atoms, include 2-thienyl, 3-thienyl, 2-furanyl, 3-furanyl, 2-oxazolyl, 4-oxazolyl, 5-oxazolyl, 3-isooxazolyl, 4-isooxazolyl, 5-isooxazolyl 2-thiazolyl, 4-thiazolyl, 5-thiazolyl, 3-isothiazolyl, 4-isothiazolyl, 5-isothiazolyl, 2-imidazolyl, 4-imidazolyl, 2-pyridyl, 3-pyridyl and 4-pyridyl groups.

The haloalkyl groups of 1 to 20 carbon atoms are exemplified by those in which at least one hydrogen atom on the above alkyl group of 1 to 20 carbon atoms is substituted with a halogen atom. Of these, fluoroalkyl groups are preferred, and perfluoroalkyl groups are more preferred.

Specific examples include fluoromethyl, difluoromethyl, trifluoromethyl, pentafluoroethyl, 2,2,2-trifluoroethyl, heptafluoropropyl, 2,2,3,3,3-pentafluoropropyl, 2,2,3,3-tetrafluoropropyl, 2,2,2-trifluoro-1-(trifluoromethyl)ethyl, nonafluorobutyl, 4,4,4-trifluorobutyl, undecafluoropentyl, 2,2,3,3,4,4,5,5,5-nonafluoropentyl, 2,2,3,3,4,4,5,5-octafluoropentyl, tridecafluorohexyl, 2,2,3,3,4,4,5,5,6,6,6-undecafluorohexyl, 2,2,3,3,4,4,5,5,6,6-decafluorohexyl and 3,3,4,4,5,5,6,6,6-nonafluorohexyl groups.

Specific examples of alkoxy groups of 1 to 20 carbon atoms include methoxy, ethoxy, n-propoxy, i-propoxy, c-propoxy, n-butoxy, i-butoxy, s-butoxy, t-butoxy, n-pentoxy, n-hexoxy, n-heptyloxy, n-octyloxy, n-nonyloxy, n-decyloxy, n-undecyloxy, n-dodecyloxy, n-tridecyloxy, n-tetradecyloxy, n-pentadecyloxy, n-hexadecyloxy, n-heptadecyloxy, n-octadecyloxy, n-nonadecyloxy and n-eicosanyloxy groups.

Specific examples of thioalkoxy (alkylthio) groups of 1 to 20 carbon atoms include methylthio, ethylthio, n-propylthio, isopropylthio, n-butylthio, isobutylthio, s-butylthio, t-butylthio, n-pentylthio, n-hexylthio, n-heptylthio, n-octylthio, n-nonylthio, n-decylthio, n-undecylthio, n-dodecylthio, n-tridecylthio, n-tetradecylthio, n-pentadecylthio, n-hexadecylthio, n-heptadecylthio, n-octadecylthio, n-nonadecylthio and n-eicosanylthio groups.

Specific examples of acyl groups of 1 to 20 carbon atoms include formyl, acetyl, propionyl, butyryl, isobutyryl, valeryl, isovaleryl and benzoyl groups.

In formula (1), R¹ to R⁶ are preferably hydrogen atoms, halogen atoms, alkyl groups of 1 to 20 carbon atoms which may be substituted with Z¹, aryl groups of 6 to 20 carbon atoms which may be substituted with Z², -NHY¹, NY²Y³, -OY⁴ or -SY⁵. Here, Y¹ to Y⁵ are preferably alkyl groups of 1 to 10 carbon atoms which may be substituted with Z¹ or aryl groups of 6 to 10 carbon atoms which may be substituted with Z², more preferably alkyl groups of 1 to 6 carbon atoms which may be substituted with Z¹ or phenyl groups which may be substituted with Z²; and even more preferably alkyl groups of 1 to 6 carbon atoms or phenyl groups.

In particular, R¹ to R⁶ are more preferably hydrogen atoms, fluorine atoms, methyl groups, phenyl groups or phenylamino groups (-N²Y³, where Y² and Y³ are phenyl groups), and R¹ to R⁴ are even more preferably hydrogen atoms with R⁵ and R⁶ at the same time being hydrogen atoms or diphenylamino groups.

In particular, in R¹ to R⁶ and Y¹ to Y⁵, Z¹ is preferably a halogen atom or an aryl group of 6 to 10 carbon atoms which may be substituted with Z³, more preferably a fluorine atom or a phenyl group, and even more preferably does not exist (i.e., is a non-substituting group); and Z² is preferably a halogen atom or an alkyl group of 1 to 10 carbon atoms which may be substituted with Z³, more preferably a fluorine atom or an alkyl group of 1 to 6 carbon atoms, and even more preferably does not exist (i.e., is a non-substituting group).

Also, Z³ is preferably a halogen atom, more preferably a fluorine atom, and even more preferably does not exist (i.e., is a non-substituting group).

From the standpoint of increasing the solubility of the aniline derivative of formula (1), the subscripts 'k' and '1' are preferably such that k+1 ≤ 8, and more preferably such that k+1 ≤ 5.

In formula (2), R⁷ to R¹⁰ are preferably hydrogen atoms, halogen atoms, alkyl groups of 1 to 4 carbon atoms, perfluoroalkyl groups of 1 to 4 carbon atoms or alkoxy groups of 1 to 4 carbon atoms; and are more preferably hydrogen atoms.

Also, to increase the solubility of the aniline derivative of formula (2) in the solvent and also to increase the uniformity of the resulting thin film, it is preferable for R¹¹ and R¹³ to both be hydrogen atoms.

In particular, it is preferable for R¹¹ and R¹³ to both be hydrogen atoms and for R¹² and R¹⁴ to each be independently a phenyl group (this phenyl group may be substituted with a halogen atom, a nitro group, a cyano group, a hydroxyl group, a thiol group, a phosphoric acid group, a sulfonic acid group, a carboxyl group, an alkoxy group of 1 to 20 carbon atoms, a thioalkoxy group of 1 to 20 carbon atoms, an alkyl group of 1 to 20 carbon atoms, a haloalkyl group of 1 to 20 carbon atoms, an alkenyl group of 2 to 20 carbon atoms, an alkynyl group of 2 to 20 carbon atoms, an aryl group of 6 to 20 carbon atoms, an aralkyl group of 7 to 20 carbon atoms or an acyl group of 1 to 20 carbon atoms) or a group of above formula (H4), more preferable for R¹¹ and R¹³ to both be hydrogen atoms and for R¹² and R¹⁴ to each be independently a phenyl group or a group of formula (3') below in which R^{19'} and R^{20'} are both phenyl groups, and even more preferable for R¹¹ and R¹³ to both be hydrogen atoms and for R¹² and R¹⁴ to both be phenyl groups.

The subscript 'm', for reasons having to do with, for example, the availability, ease of production and cost of the compound, is preferably from 2 to 4; to increase the solubility in the solvent, is more preferably 2 or 3; and to strike a good balance among the compound availability, ease of production, production cost and solubility in the solvent and the transparency of the resulting thin film, is most preferably 2.

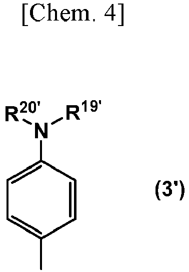

Commercial products and compounds synthetized by known methods, such as the methods mentioned in the above-cited patent literature, may be used as the aniline derivatives of formulas (1) and (2). In both cases, it is preferable to use a compound which, prior to preparation of the organic functional ink, has been purified by recrystallization, vapor deposition or the like. By using a purified compound, the characteristics of the electronic device having a thin film obtained from the ink can be further increased. In cases where purification is carried out by recrystallization, use can be made of 1,4-dioxane, tetrahydrofuran or the like as the solvent.

In this invention, the organic functional materials (charge-transporting substances) represented by formulas (1) and (2) may be a single compound selected from among the compounds of formulas (1) and (2) (i.e., having a molecular weight distribution dispersity of 1), or may be a combination of two or more compounds.

Specific examples of organic functional materials that may be suitably used in the invention include, but are not limited to, the following.

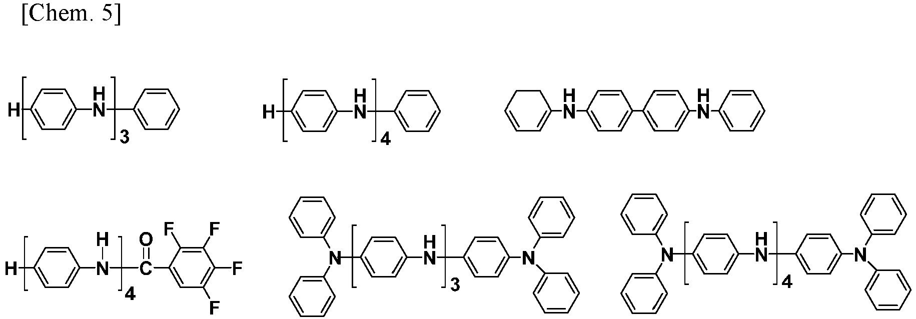

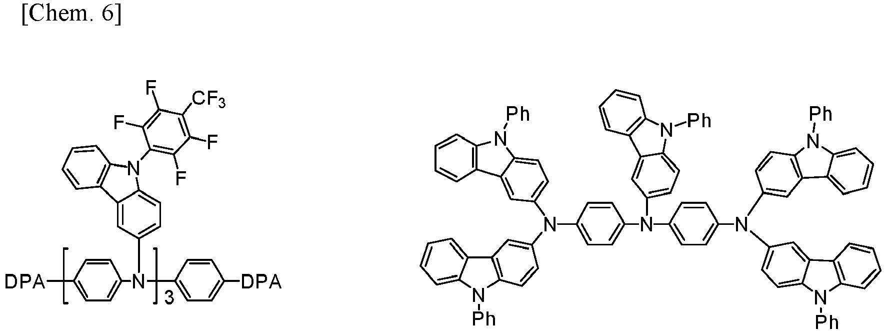

### (wherein DPA stands for a diphenylamino group)

Depending on the intended use of the resulting functional film, the organic functional ink used in this invention may include, in addition to the above-described aniline derivative or other organic functional material, a dopant substance for such purposes as to increase the charge transportability thereof.

The dopant substance is not particularly limited, provided that it dissolves in at least one solvent used in the ink. Both inorganic dopant substances and organic dopants substances may be used.

The inorganic and organic dopant substances may be of one type used alone, or two or more types may be used in combination.

In addition, the dopant substance may be a substance which initially manifests or enhances functionality as a dopant substance through, for example, the external stimulus of heating during baking, such as by way of the removal of an intramolecular portion, in the course of obtaining from the ink an organic functional film that is a solid film. For example, it may be an arylsulfonic acid ester compound protected by a group from which a sulfonic acid group readily dissociates.

The molecular weight of organic dopants such as arylsulfonic acid compounds and arylsulfonic acid ester compounds is not particularly limited. However, taking into account the solubility in organic solvents when used together with the aniline derivative used in this invention, the molecular weight is preferably not more than 4,000, more preferably not more than 3,000, and even more preferably not more than 2,000.

In this invention, heteropolyacids are especially preferred as inorganic dopant substances.

"Heteropolyacid" refers to a polyacid having a structure in which a heteroatom is positioned at the center of the molecule--typically the Keggin-type chemical structure shown in formula (H1) or the Dawson-type chemical structure shown in formula (H2), and which is obtained by the condensation of an isopolyacid that is an oxoacid of vanadium (V), molybdenum (Mo), tungsten (W) or the like with an oxoacid of a different element. Examples of such oxoacids of a different element include primarily oxoacids of silicon (Si), phosphorus (P) and arsenic (As).

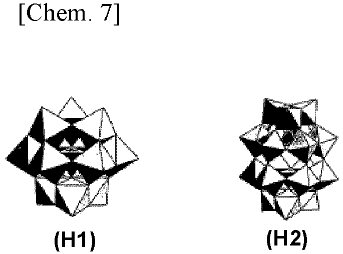

Examples of heteropolyacids include phosphomolybdic acid, silicomolybdic acid, phosphotungstic acid, silicotungstic acid and phosphotungstomolybdic acid. These may be used singly, or two or more may be used in combination. These heteropolyacids may be acquired as a commercial product or may be synthesized by a known method.

In particular, when a single heteropolyacid is used, this single heteropolyacid is preferably phosphotungstic acid or phosphomolybdic acid, and more preferably phosphotungstic acid. When two or more heteropolyacids are used, at least one of the two or more heteropolyacids is preferably phosphotungstic acid or phosphomolybdic acid, and more preferably phosphotungstic acid.

Even a heteropolyacid having, in quantitative analysis such as elemental analysis, numbers for the elements which are higher or lower than in the structure indicated by the general formula may be used in this invention, provided that it was acquired as a commercial product or was suitably synthesized according to a known method of synthesis.

For example, phosphotungstic acid is generally represented by the chemical formula H₃(PW₁₂O₄₀)·nH₂O and phosphomolybdic acid is generally represented by the chemical formula H₃(PMo₁₂O₄₀)·nH₂O. In quantitative analysis, regardless of whether the numbers for the elements P (phosphorus), O (oxygen) and W (tungsten) or Mo (molybdenum) within these formulas are high or low, so long as the heteropolyacid was acquired as a commercial product or suitably synthesized by a known method of synthesis, it may be used in this invention. In such cases, the mass of the heteropolyacid specified in this invention refers not to the mass of pure phosphotungstic acid within the product of synthesis or the commercial product (phosphotungstic acid content), but rather, in the form that is available as a commercial product or the form that can be isolated by a known method of synthesis, to the total mass in a state that includes water of hydration and other impurities.

The amount of heteropolyacid used may be set to a molar ratio, relative to unity (1) for the aniline derivative or other organic functional material, of from about 0.001 to about 50.0, preferably from about 0.01 to about 20.0, and more preferably from about 0.1 to about 10.0.

As for organic dopant substances, use can be made of, in particular, tetracyanoquinodimethane derivatives and benzoquinone derivatives.

Specific examples of tetracyanoquinodimethane derivatives include 7,7,8,8-tetracyanoquinodimethane (TCNQ) and halotetracyanoquinodimethanes of formula (H3).

Specific examples of benzoquinone derivatives include tetrafluoro-1,4-benzoquinone (F4BQ), tetrachloro-1,4-benzoquinone (chloranil), tetrabromo-1,4-benzoquinone and 2,3-dichloro-5,6-dicyano-1,4-benzoquinone (DDQ).

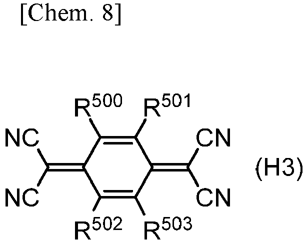

In the formula, R⁵⁰⁰ to R⁵⁰³ are each independently a hydrogen atom or a halogen atom, with at least one being a halogen atom, preferably at least two being halogen atoms, more preferably at least three being halogen atoms, and most preferably all being halogen atoms.

The halogen atoms are exemplified in the same way as above, and are preferably fluorine atoms or chlorine atoms, and more preferably fluorine atoms.

Specific examples of such halotetracyanoquinodimethanes include
2-fluoro-7,7,8,8-tetracyanoquinodimethane, 2-chloro-7,7,8,8-tetracyanoquinodimethane,
2,5-difluoro-7,7,8,8-tetracyanoquinodimethane,
2,5-dichloro-7,7,8,8-tetracyanoquinodimethane,
2,3,5,6-tetrachloro-7,7,8,8-tetracyanoquinodimethane and
2,3,5,6-tetrafluoro-7,7,8,8-tetracyanoquinodimethane (F4TCNQ).

The tetracyanoquinodimethane derivative and benzoquinone derivative are used in an amount, relative to the aniline derivative or other organic functional material, of preferably from 0.0001 to 100 equivalents, more preferably from 0.01 to 50 equivalents, and even more preferably from 1 to 20 equivalents.

Specific examples of arylsulfonic acid compounds include benzenesulfonic acid, tosylic acid, p-styrenesulfonic acid, 2-naphthalenesulfonic acid, 4-hydroxybenzenesulfonic acid, 5-sulfosalicyclic acid, p-dodecylbenzenesulfonic acid, dihexylbenzenesulfonic acid, 2,5-dihexylbenzenesulfonic acid, dibutylnaphthalenesulfonic acid, 6,7-dibutyl-2-naphthalenesulfonic acid, dodecylnaphthalenesulfonic acid, 3-dodecyl-2-naphthalenesulfonic acid, hexylnaphthalenesulfonic acid, 4-hexyl-1-naphthalenesulfonic acid, octylnaphthalenesulfonic acid, 2-octyl-1-napthalenesulfonic acid, hexylnaphthalenesulfonic acid, 7-hexyl-1-naphthalenesulfonic acid, 6-hexyl-2-naphthalenesulfonic acid, dinonylnaphthalenesulfonic acid, 2,7-dinonyl-4-naphthalenesulfonic acid, dinonylnaphthalenedisulfonic acid, 2,7-dinonyl-4,5-naphthalenedisulfonic acid, the 1,4-benzodioxanedisulfonic acid compounds mentioned in WO 2005/000832, the arylsulfonic acid compounds mentioned in WO 2006/025342 and the arylsulfonic acid compounds mentioned in WO 2009/096352.

Preferred examples of arylsulfonic acid compounds include arylsulfonic acid compounds of formula (H4) or (H5).

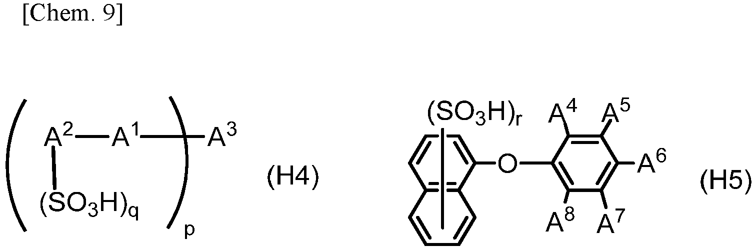

Here, A¹ is -O- or -S-, and is preferably -O-.

A² represents a naphthalene ring or an anthracene ring, and is preferably a naphthalene ring.

A³ represents a divalent to tetravalent perfluorobiphenyl group and the subscript 'p' is an integer which represents the number of bonds between A¹ and A³ and satisfies the condition 2 ≤ p ≤ 4, with A³ being a perfluorobiphenyldiyl group, preferably a perfluorobiphenyl-4,4'-diyl group, and p being preferably 2.

The subscript 'q' is an integer which represents the number of sulfonic acid groups that bond with A² and satisfies the condition 1 ≤ q ≤ 4, and is most preferably 2.

A⁴ to A⁸ are each independently a hydrogen atom, a halogen atom, a cyano group, an alkyl group of 1 to 20 carbon atoms, a halogenated alkyl group of 1 to 20 carbon atoms or a halogenated alkenyl group of 2 to 20 carbon atoms. At least three of A⁴ to A⁸ are halogen atoms.

Examples of halogenated alkyl groups of 1 to 20 carbon atoms include trifluoromethyl, 2,2,2-trifluoroethyl, 1,1,2,2,2-pentafluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl and 1,1,2,2,3,3,4,4,4-nonafluorobutyl groups.

Examples of halogenated alkenyl groups having 2 to 20 carbon atoms include perfluorovinyl, perfluoropropenyl (perfluoroallyl) and perfluorobutenyl groups.

In addition, the halogen atoms and the alkyl groups of 1 to 20 carbon atoms are exemplified in the same way as above, with fluorine atoms being preferred as the halogen atoms.

Of these, A⁴ to A⁸ are preferably hydrogen atoms, halogen atoms, cyano groups, alkyl groups of 1 to 10 carbon atoms, halogenated alkyl groups of 1 to 10 carbon atoms or halogenated alkenyl groups of 2 to 10 carbon atoms, with at least three of A⁴ to A⁸ being preferably fluorine atoms; more preferably hydrogen atoms, fluorine atoms, cyano groups, alkyl groups of 1 to 5 carbon atoms, fluorinated alkyl groups of 1 to 5 carbon atoms, or fluorinated alkenyl groups of 2 to 5 carbon atoms, with at least three of A⁴ to A⁸ being fluorine atoms; and even more preferably hydrogen atoms, fluorine atoms, cyano groups, perfluoroalkyl groups of 1 to 5 carbon atoms, or perfluoroalkenyl groups of 1 to 5 carbon atoms, with A⁴, A⁵ and A⁸ being fluorine atoms.

Here, "perfluoroalkyl group" refers to an alkyl group in which all the hydrogen atoms are substituted with fluorine atoms, and "perfluoroalkenyl group" refers to an alkenyl group in which all the hydrogen atoms are substituted with fluorine atoms.

The subscript 'r' is an integer which represents the number of sulfonic acid groups bonded to the naphthalene ring and satisfies the condition 1 ≤ r ≤ 4, and is preferably from 2 to 4, and most preferably 2.

Specific examples of suitable arylsulfonic acid compounds include, but are not limited to, those shown below.

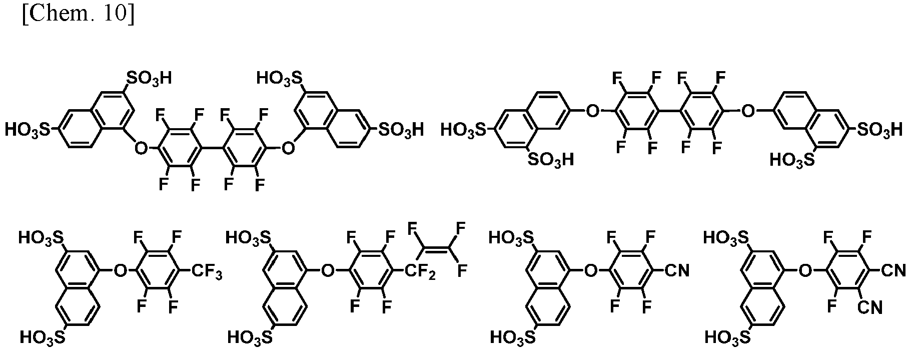

The amount of arylsulfonic acid compound used may be set to a molar ratio, relative to unity (1) for the aniline derivative or other organic functional material, of from about 0.01 to about 20.0, and preferably from about 0.4 to about 5.0.

The arylsulfonic acid compound used may be a commercial product, although it may also be synthesized by a known method such as those described in WO 2006/025342 and WO 2009/096352.

As for arylsulfonic acid ester compounds, these are exemplified by the arylsulfonic acid ester compounds mentioned in WO 2017/217455, the arylsulfonic acid ester compounds mentioned in WO 2017/217457 and the arylsulfonic acid ester compounds mentioned in Japanese Patent Application No. 2017-243631. Specific examples include those having any of formulas (H6) to (H8) below. 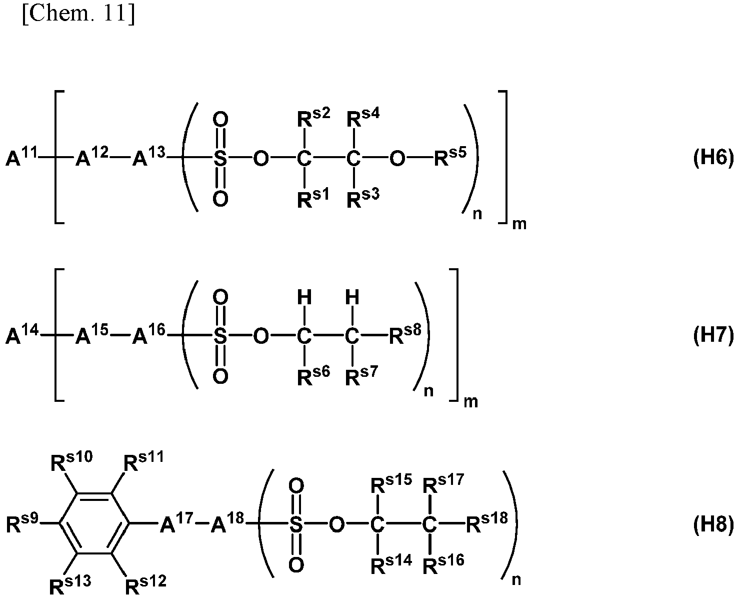 (wherein m is an integer that satisfies the condition 1 ≤ m ≤ 4, and is preferably 2; and n is an integer that satisfies the condition 1 ≤ n ≤ 4, and is preferably 2)

In formula (H6), A¹¹ is an m-valent group derived from perfluorobiphenyl.

A¹² is -O- or -S-, and is preferably -O-.

A¹³ is an (n+1)-valent group derived from naphthalene or anthracene, and is preferably a group derived from naphthalene.

R^{s1} to R^{s4} are each independently a hydrogen atom or a linear or branched alkyl group of 1 to 6 carbon atoms, and R^{s5} is a monovalent hydrocarbon group of 2 to 20 carbon atoms which may be substituted.

Specific examples of linear or branched alkyl groups of 1 to 6 carbon atoms include methyl, ethyl, n-propyl, isopropyl, n-butyl, isobutyl, t-butyl and n-hexyl groups. Alkyl groups of 1 to 3 carbon atoms are preferred.

The monovalent hydrocarbon groups of 2 to 20 carbon atoms may be linear, branched or cyclic. Specific examples include alkyl groups such as ethyl, n-propyl, isopropyl, n-butyl, isobutyl and t-butyl groups; and aryl groups such as phenyl, naphthyl and phenanthryl groups.

In particular, of R^{s1} to R^{s4}, it is preferable for R^{s1} or R^{s3} to be a linear alkyl group of 1 to 3 carbon atoms, with the others being hydrogen atoms, or for R^{s1} to be a linear alkyl group of 1 to 3 carbon atoms and R^{s2} to R^{s4} to be hydrogen atoms. Here, the linear alkyl group of 1 to 3 carbon atoms is preferably a methyl group.

Also, R^{s5} is preferably a linear alkyl group of 2 to 4 carbon atoms or a phenyl group.

In formula (H7), A¹⁴ is an m-valent hydrocarbon group of 6 to 20 carbon atoms which includes at least one aromatic ring and may be substituted. This hydrocarbon group is a group obtained by removing m hydrogen atoms from a hydrocarbon compound of 6 to 20 carbon atoms which includes at least one aromatic ring.

Examples of such hydrocarbon compounds include benzene, toluene, xylene, ethylbenzene, biphenyl, naphthalene, anthracene and phenanthrene.

Some or all hydrogen atoms on the hydrocarbon group may additionally be substituted with substituents. Examples of such substituents include fluorine atoms, chlorine atoms, bromine atoms, iodine atoms, nitro groups, cyano groups, hydroxyl groups, amino groups, silanol groups, thiol groups, carboxyl groups, sulfonic acid ester groups, phosphoric acid groups, phosphoric acid ester groups, ester groups, thioester groups, amide groups, monovalent hydrocarbon groups, organooxy groups, organoamino groups, organosilyl groups, organothio groups, acyl groups and sulfo groups.

Of these, A¹⁴ is preferably a group derived from benzene, biphenyl or the like.

Also, A¹⁵ is -O- or -S-, and is preferably -O-.

A¹⁶ is an (n+1)-valent aromatic hydrocarbon group of 6 to 20 carbon atoms, which aromatic hydrocarbon group is a group obtained by removing (n+1) hydrogen atoms from the aromatic ring of an aromatic hydrocarbon compound of 6 to 20 carbon atoms.

Such aromatic hydrocarbon compounds include benzene, toluene, xylene, biphenyl, naphthalene, anthracene and pyrene.

Of these, A¹⁶ is preferably a group derived from naphthalene or anthracene, and is more preferably a group derived from naphthalene.

R^{s6} and R^{s7} are each independently a hydrogen atom or a linear or branched monovalent aliphatic hydrocarbon group, and R^{s8} is a linear or branched monovalent aliphatic hydrocarbon group. The sum of the number of carbon atoms on R^{s6}, R^{s7} and R^{s8} is 6 or more. The upper limit in the sum of the number of carbon atoms on R^{s6}, R^{s7} and R^{s8}, although not particularly limited, is preferably 20 or less, and more preferably 10 or less.

Specific examples of the above linear or branched monovalent aliphatic hydrocarbon groups include alkyl groups of 1 to 20 carbon atoms, such as methyl, ethyl, n-propyl, isopropyl, n-butyl, isobutyl, t-butyl, n-hexyl, n-octyl, 2-ethylhexyl and decyl groups; and alkenyl groups of 2 to 20 carbon atoms, such as vinyl, 1-propenyl, 2-propenyl, isopropenyl, 1-methyl-2-propenyl, 1-butenyl, 2-butenyl, 3-butenyl and hexenyl groups.

Of these, R^{s6} is preferably a hydrogen atom, and R^{s7} and R^{s8} are preferably each independently an alkyl group of 1 to 6 carbon atoms.

In formula (H8), R^{s9} to R^{s13} are each independently a hydrogen atom, a nitro group, a cyano group, a halogen atom, an alkyl group of 1 to 10 carbon atoms, a halogenated alkyl group of 1 to 10 carbon atoms or a halogenated alkenyl group of 2 to 10 carbon atoms.

The alkyl group of 1 to 10 carbon atoms may be linear, branched or cyclic. Specific examples include methyl, ethyl, n-propyl, isopropyl, n-butyl, isobutyl, s-butyl, t-butyl, n-pentyl, cyclopentyl, n-hexyl, cyclohexyl, n-heptyl, n-octyl, n-nonyl and n-decyl groups.

The halogenated alkyl group of 1 to 10 carbon atoms is not particularly limited, provided that it is a group in which some or all hydrogen atoms on the above-described alkyl group of 1 to 10 carbon atoms are substituted with halogen atoms. Specific examples include trifluoromethyl, 2,2,2-trifluoroethyl, 1,1,2,2,2-pentafluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl and 1,1,2,2,3,3,4,4,4-nonafluorobutyl groups.

The halogenated alkenyl group of 2 to 10 carbon atoms is not particularly limited, provided that it is a group in which some or all of the hydrogen atoms on an alkenyl group of 2 to 10 carbon atoms have been substituted with halogen atoms. Specific examples include perfluorovinyl, perfluoro-1-propenyl, perfluoro-2-propenyl, perfluoro-1-butenyl, perfluoro-2-butenyl and perfluoro-3-butenyl groups.

Of these groups, R^{s9} is preferably a nitro group, a cyano group, a halogenated alkyl group of 1 to 10 carbon atoms or a halogenated alkenyl group of 2 to 10 carbon atoms; more preferably a nitro group, a cyano group, a halogenated alkyl group of 1 to 4 carbon atoms or a halogenated alkenyl group of 2 to 4 carbon atoms; and even more preferably a nitro group, a cyano group, a trifluoromethyl group or a perfluoropropenyl group.

R^{s10} to R^{s13} are preferably halogen atoms, and more preferably fluorine atoms.

A¹⁷ is -O-, -S- or -NH-, and is preferably -O-.

A¹⁸ is an (n+1)-valent aromatic hydrocarbon group of 6 to 20 carbon atoms. This aromatic hydrocarbon group is a group obtained by removing (n+1) hydrogen atoms from the aromatic ring on an aromatic hydrocarbon compound of 6 to 20 carbon atoms.

Examples of such aromatic hydrocarbon compounds include benzene, toluene, xylene, biphenyl, naphthalene, anthracene and pyrene.

Of these, A¹⁸ is preferably a group derived from naphthalene or anthracene, and is more preferably a group derived from naphthalene.

R^{s14} to R^{s17} are each independently a hydrogen atom or a linear or branched monovalent aliphatic hydrocarbon group of 1 to 20 carbon atoms.

Specific examples of monovalent aliphatic hydrocarbon groups include alkyl groups of 1 to 20 carbon atoms, such as methyl, ethyl, n-propyl, isopropyl, n-butyl, isobutyl, s-butyl, t-butyl, n-pentyl, cyclopentyl, n-hexyl, cyclohexyl, n-heptyl, n-octyl, n-nonyl, n-decyl, n-undecyl and n-dodecyl groups; and alkenyl groups of 2 to 20 carbon atoms, such as vinyl, 1-propenyl, 2-propenyl, isopropenyl, 1-methyl-2-propenyl, 1-butenyl, 2-butenyl, 3-butenyl and hexenyl groups. Alkyl groups of 1 to 20 carbon atoms are preferred, alkyl groups of 1 to 10 carbon atoms are more preferred, and alkyl groups of 1 to 8 carbon atoms are even more preferred.

R^{s18} is a linear or branched monovalent aliphatic hydrocarbon group of 1 to 20 carbon atoms, or OR^{s19}. R^{s19} is a monovalent hydrocarbon group of 2 to 20 carbon atoms which may be substituted.

The linear or branched monovalent aliphatic hydrocarbon group of 1 to 20 carbon atoms serving as R^{s18} is exemplified in the same way as above.

In cases where R^{s18} is a monovalent aliphatic hydrocarbon group, R^{s18} is preferably an alkyl group of 1 to 20 carbon atoms, more preferably an alkyl group of 1 to 10 carbon atoms, and even more preferably an alkyl group of 1 to 8 carbon atoms.

The monovalent hydrocarbon group of 2 to 20 carbon atoms serving as R^{s19} is exemplified by, in addition to the above-described monovalent aliphatic hydrocarbon groups other than methyl, aryl groups such as phenyl, naphthyl and phenanthryl groups.

Of these, R^{s19} is preferably a linear alkyl group of 2 to 4 carbon atoms or a phenyl group.

Examples of the substituents that the above monovalent hydrocarbon groups may have include fluorine atoms, alkoxy groups of 1 to 4 carbon atoms, nitro groups and cyano groups.

Specific examples of suitable arylsulfonic acid ester compounds include, but are not limited to, those shown below.

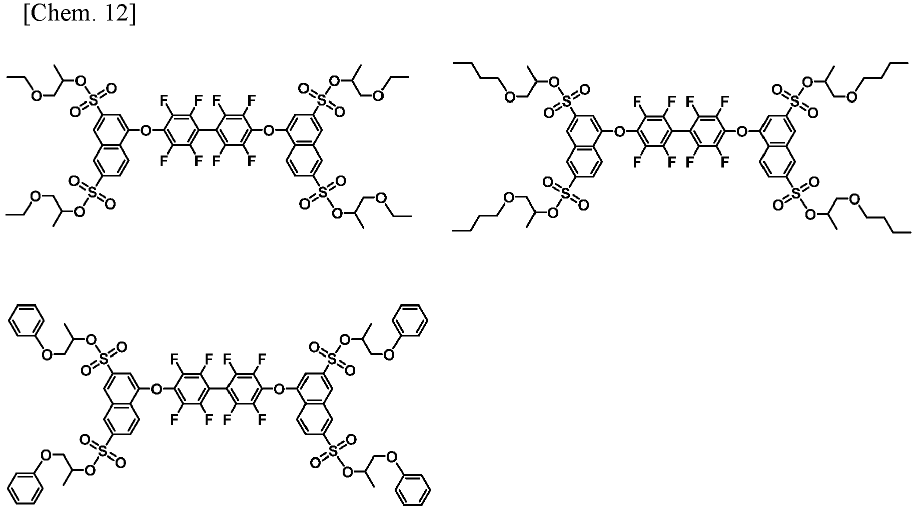

The amount of arylsulfonic acid ester compound used, expressed as a molar ratio relative to unity (1) for the aniline derivative or other organic functional material, is preferably from about 0.01 to about 20.0, and more preferably from about 0.05 to about 15.

In this invention, to effectively suppress the pile-up effect when an organic functional ink is applied by an inkjet process within a bank formed on a substrate, it is preferable to use as the dopant substance at least an arylsulfonic acid compound or an arylsulfonic acid ester compound, and more preferable to use an arylsulfonic acid compound.

The solids concentration of the organic functional ink used in the invention is generally from about 0.1 wt% to about 20.0 wt%; to increase the ink coatability, it is preferably from about 0.5 wt% to about 10.0 wt%, and even more preferably from about 1.0 wt% to about 5.0 wt%. The solids concentration is suitably set while taking into account the thickness and other properties of the functional film to be produced.

The viscosity of the organic functional ink varies according to, for example, the amount of droplets deposited in the inkjet process, and so cannot be strictly specified, although it is generally not more than 15 mPa·s, and preferably not more than 10 mPa·s, at 25°C.

The organic functional ink has a surface tension at 25°C which is generally from 20 to 50 mN/m, preferably from 25 to 45 mN/m, and more preferably from 37 to 42 mN/m.

The viscosity is a value measured with the TVE-25 viscometer from Toki Sangyo Co., Ltd. The surface tension is a value measured with the CBVP-Z automatic surface tensiometer from Kyowa Interface Science Co., Ltd.

The viscosity and surface tension of the organic functional ink can be adjusted by changing, for example, the types of the above-described ink solvents, the proportions thereof and the solids concentration of the ink while taking into account various factors such as the desired film thickness.

In this invention, the method of preparing the organic functional ink is not particularly limited. Examples include methods that entail dissolving the above-described aniline derivative or other organic functional material in a triethylene glycol-containing ink solvent (mixed solvent), and methods that entail dissolving the organic functional material in triethylene glycol and then mixing in the other solvents.

When a dopant is used, the addition thereof may be carried out in any order.

Also, when the organic functional ink is prepared, from the standpoint of reproducibly obtaining a thin film having a higher flatness, after the organic functional material, dopant substance and the like have been dissolved in the organic solvents, it is desirable to carry out filtration using, for example, a sub-micron filter.

The substrate with bank on which the above-described organic functional ink is to be applied is not particularly limited, provided that it is a substrate on which a predetermined pattern has been formed by a known photoresist process. A plurality of openings defined by banks are typically present on the substrate.

The dimensions of the openings are generally such that the long sides are from 100 to 210 µm, the short sides are from 40 µm × 100 µm, and the bank has a taper angle of from 20 to 80°.

The material making up the substrate is not particularly limited. In this invention, examples include transparent electrode materials such as indium tin oxide (ITO) and indium zinc oxide (IZO) that are used as anode materials in electronic devices; metallic anode materials composed of metals such as aluminum, gold, silver, copper and indium, or alloys thereof; and polymeric anode materials having high charge transportability, such as polythiophene derivatives and polyaniline derivatives. One that has been subjected to planarizing treatment is preferred.

A substrate with an organic functional film thereon can be produced by applying the above-described organic functional ink within banks on a substrate with banks by an inkjet process using a known inkjet apparatus, and subsequently applying a vacuum and also, if necessary, heating so as to remove the solvent from the organic functional ink that has been applied within the banks, thereby forming an organic functional film. By depositing other functional films on top of this organic functional film, an electronic device such as an organic EL device can be manufactured.

The heating/baking atmosphere during and after inkjet application is not particularly limited, and may be an open-air atmosphere, a nitrogen or other inert gas atmosphere, or a vacuum. Depending on the type of dopant substance used together with the aniline derivative or other organic functional material, heating and baking in an open-air atmosphere sometimes enables a functional film having good properties to be reproducibly obtained.

The degree of vacuum when a vacuum is applied is not particularly limited so long as the ink solvent evaporates. However, in this invention, the degree of vacuum is generally 1,000 Pa or less, preferably 100 Pa or less, more preferably 50 Pa or less, even more preferably 25 Pa or less, and still more preferably 10 Pa or less.

The vacuum time is not particularly limited so long as the solvent evaporates, but is generally from about 0.1 minute to about 60 minutes, and preferably from about 1 minute to about 30 minutes.

The temperature when heating and baking is suitably set in the range of about 100°C to about 260°C while taking into account such factors as the intended use of the resulting functional film, and the types and boiling points of the solvents. When the above-described aniline derivative is used as the organic functional material and the resulting functional film is to be used as a hole-inj ecting layer in an organic EL device, from the standpoint of increasing the charge transportability of the functional film, the baking temperature is preferably between about 140°C and about 250°C, and more preferably between about 145°C and about 240°C.

During heating and baking, a temperature change in two or more steps may be carried out for such purposes as to achieve more uniform film formability or to induce the reaction to proceed on the substrate. Heating may be carried out using a suitable apparatus such as a hot plate or an oven.

The thickness of the organic functional film formed in this invention is not particularly limited. However, when the organic functional film is to be used as a hole-injecting layer, hole-transporting layer or hole injecting-and-transporting layer in an organic EL device, a film thickness of from 5 to 300 nm is preferred. Methods for changing the film thickness include, for example, changing the solids concentration in the organic functional ink and changing the amount of solution on the substrate at the time of application.

The electronic device fabricated in this invention has, as described above, a substrate with organic functional film thereon that has been formed by applying, via an inkjet process, an organic functional ink that includes an organic functional material and a solvent containing from 3 to 17 wt% of triethylene glycol within the banks on a substrate with banks thereon, and then removing the solvent by applying a vacuum. This is exemplified by an electronic device having a pair of electrodes, wherein at least one of the electrodes has a substrate with organic functional film thereon produced by forming banks of a predetermined pattern on the electrode surface and applying the above organic functional ink by an inkjet process to the interior of the banks, and also has various functional films formed on the substrate with organic functional film.

In particular, the electronic device fabricated in this invention is preferably an organic EL device in which the electrode having banks formed thereon is an anode and the organic functional film is a hole-injecting layer or hole injecting-and-transporting layer formed on this anode, and which may have, but is not limited to, one of the following configurations (a) to (f).

The organic functional film produced from the above-described aniline derivative-containing organic functional ink may be used in organic EL devices as a hole-injecting layer, a hole-transporting layer or a hole injecting-and-transporting layer. However, in this invention, because the ink is applied by an inkjet process within banks formed on the anode, it is preferably used as a hole-injecting layer or a hole injecting-and-transporting layer, and more preferably used as a hole-injecting layer.
(a) anode/hole-injecting layer/hole-transporting layer/light-emitting layer/electron-transporting layer/electron-injecting layer/cathode
(b) anode/hole-injecting layer/hole-transporting layer/light-emitting layer/electron-inj ecting-and-transporting layer/cathode
(c) anode/hole-inj ecting-and-transporting layer/light-emitting layer/electron-transporting layer/electron-inj ecting layer/cathode
(d) anode/hole-inj ecting-and-transporting layer/light-emitting layer/electron-inj ecting-and-transporting layer/cathode
(e) anode/hole-injecting layer/hole-transporting layer/light-emitting layer/cathode
(f) anode/hole-inj ecting-and-transporting layer/light-emitting layer/cathode

In the above configurations, where necessary, an electron-blocking layer or the like may be provided between the light-emitting layer and the anode, and a hole-blocking layer or the like may be provided between the light-emitting layer and the cathode. Also, the hole-injecting layer, hole-transporting layer or hole injecting-and-transporting layer may additionally have the function of, for example, an electron-blocking layer; and the electron-injecting layer, electron-transporting layer or electron injecting-and-transporting layer may additionally have the function of, for example, a hole-blocking layer. In addition, aside from between the anode and the hole-injecting layer or hole injecting-and-transporting layer, where necessary, it is also possible in this invention to provide optional functional layers between various layers.

As used herein, "hole-injecting layer," "hole-transporting layer" and "hole-injecting-and-transporting layer" refer to layers which are formed between the light-emitting layer and the anode and which have the function of transporting holes from the anode to the light-emitting layer. When only one layer of hole-transporting material is provided between the light-emitting layer and the anode, this is a "hole-injecting-and-transporting layer"; when two or more layers of hole-transporting material are provided between the light-emitting layer and the anode, the layer that is closer to the anode is a "hole-injecting layer" and the other layer is a "hole-transporting layer." In particular, a thin film having not only an excellent ability to accept holes from the anode but also an excellent ability to inject holes into the hole-transporting (light-emitting) layer may be used as the hole-injecting (transporting) layer.

In addition, "electron-injecting layer," "electron-transporting layer" and "electron-injecting-and-transporting layer" refer to layers which are formed between the light-emitting layer and the cathode and which have the function of transporting electrons from the cathode to the light-emitting layer. When only one layer of electron-transporting material is provided between the light-emitting layer and the cathode, this is an "electron-injecting-and-transporting layer"; when two or more layers of electron-transporting material are provided between the light-emitting layer and the cathode, the layer that is closer to the cathode is an "electron-injecting layer" and the other layer is an "electron-transporting layer."

The "light-emitting layer" is an organic layer having a light-emitting function. When a doping system is used, this layer includes a host material and a dopant material. The function of the host material is primarily to promote the recombination of electrons and holes and to confine the resulting excitons within the light-emitting layer. The function of the dopant material is to cause the excitons obtained by recombination to efficiently luminesce. In the case of phosphorescent devices, the host material functions primarily to confine within the light-emitting layer the excitons generated by the dopant.

The materials and method employed to fabricate an organic EL device using the above-described aniline derivative-containing organic functional ink are exemplified by, but not limited to, those described below.

An example of a method for fabricating an OLED device having a hole-injecting layer made of a thin film obtained from the above organic functional ink is given below. It is preferable for the electrodes to be cleaned beforehand with alcohol, pure water or the like, or to be surface-treated by UV-ozone treatment, oxygen-plasma treatment or the like, in such a way as not to adversely affect the electrodes.

Using the above organic functional ink, a hole-injecting layer is formed by the above method on the anode substrate on which banks of a predetermined pattern have already been formed. The workpiece is then introduced into a vacuum deposition system, and a hole-transporting layer, a light-emitting layer, an electron-transporting layer/hole-blocking layer, an electron-injecting layer and a cathode metal are successively vapor-deposited. In an alternative version of this method, instead of forming a hole-transporting layer and a light-emitting layer by vapor deposition, these films are formed by wet processes using a hole-transporting layer-forming composition that contains a hole transporting polymer and using a light-emitting layer-forming composition that contains a light-emitting polymer. Where necessary, an electron-blocking layer may be provided between the light-emitting layer and the hole-transporting layer.

Illustrative examples of anode materials include transparent electrodes such as indium tin oxide (ITO) and indium zinc oxide (IZO), and metal anodes made of a metal such as aluminum or alloys thereof. An anode material on which planarizing treatment has been carried out is preferred. Use can also be made of polythiophene derivatives and polyaniline derivatives having a high charge transportability.

Examples of other metals that may make up the metal anode include, but are not limited to, gold, silver, copper and indium, as well as alloys of these.

Examples of hole-transporting layer-forming materials include triarylamines such as (triphenylamine) dimer derivatives, [(triphenylamine) dimer] spirodimer, N,N'-bis(naphthalen-1-yl)-N,N'-bis(phenyl)benzidine (α-NPD), 4,4',4"-tris[3-methylphenyl(phenyl)amino]triphenylamine (m-MTDATA) and 4,4',4"-tris[1-naphthyl(phenyl)amino]triphenylamine (1-TNATA); and oligothiophenes such as 5,5"-bis-{4-[bis(4-methylphenyl)amino]phenyl}-2,2':5',2"-terthiophene (BMA-3T).

Light-emitting layer-forming materials are exemplified by oligomeric light-emitting materials, including aluminum and other metal complexes of 8-hydroxyquinoline, metal complexes of 10-hydroxybenzo[h]quinoline, bisstyrylbenzene derivatives, bisstyrylarylene derivatives, metal complexes of (2-hydroxyphenyl)benzothiazole and silole derivatives; and systems obtained by mixing a light-emitting material and an electron-transferring material into a polymeric compound such as poly(p-phenylene vinylene), poly(2-methoxy-5-(2-ethylhexyloxy)-1,4-phenylene vinylene), poly(3-alkylthiophene) or polyvinylcarbazole.

Alternatively, when forming the light-emitting layer by vapor deposition, co-deposition together with a light-emitting dopant may be carried out. Examples of light-emitting dopants include metal complexes such as tris(2-phenylpyridine)iridium(III) (Ir(ppy)₃), and condensed polycyclic aromatic compounds such as rubrene and other naphthalene derivatives, quinacridone derivatives, and perylene.

Examples of materials that form an electron-transporting layer/hole-blocking layer include oxydiazole derivatives, triazole derivatives, phenanthroline derivatives, phenylquinoxaline derivatives, benzimidazole derivatives and pyrimidine derivatives.

Examples of materials that form an electron-injecting layer include metal oxides such as lithium oxide (Li₂O), magnesium oxide (MgO) and alumina (Al₂O₃), and metal fluorides such as lithium fluoride (LiF) and sodium fluoride (NaF).

Examples of cathode materials include aluminum, magnesium-silver alloys and aluminum-lithium alloys.

An example of a material that forms an electron-blocking layer is tris(phenylpyrazole)iridium.

Examples of hole-transporting polymers include
poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)], poly[(9,9-bis{1'-penten-5'-yl}fluorenyl-2,7-diyl)-co-(N,N'-bis{p-butylphenyl}-1,4-diaminophenylene)], poly[N,N'-bis(4-butylphenyl)-N,N'-bis(phenyl)-benzidine] end-capped with polysilsesquioxane and poly[(9,9-dioctylfluorenyl-2,7-diyl)-co-(4,4'-(N-(p-butylphenyl))diphenylamine)].

Examples of light-emitting polymers include polyfluorene derivatives such as poly(9,9-dialkylfluorene) (PDAF), poly(phenylene vinylene) derivatives such as poly(2-methoxy-5-(2'-ethylhexoxy)-1,4-phenylene vinylene) (MEH-PPV), polythiophene derivatives such as poly(3-alkylthiophene) (PAT), and polyvinylcarbazole (PVCz).

The materials which make up the anode, the cathode and the layers formed therebetween differ according to whether a device provided with a bottom emission structure or a top emission structure is to be fabricated, and so are suitably selected while taking this into account.

Typically, in a device having a bottom emission structure, a transparent anode is used on the substrate side and light is extracted from the substrate side, whereas in a device having a top emission structure, a reflective anode made of metal is used and light is extracted from the transparent electrode (cathode) side in the opposite direction from the substrate. For example, with regard to the anode material, when fabricating a device having a bottom emission structure, a transparent anode of ITO or the like is used, and when fabricating a device having a top emission structure, a reflective anode of Al/Nd or the like is used.

To prevent deterioration of the device characteristics, the organic EL device of the invention may be sealed in the usual manner with, if necessary, a desiccant or the like.

With the present invention described above, ink pile-up within banks can be effectively suppressed. Specifically, pile-up can be suppressed to, in terms of the subsequently described pile-up index, a high value of generally at least 60%, preferably at least 63%, more preferably at least 66%, even more preferably at least 69%, and still more preferably at least 72%.

The inventive methods for manufacturing a substrate with organic functional film thereon and an electronic device can be suitably used in the fabrication of electronic devices in which, as described above, a hole-injecting layer or a hole injecting-and-transporting layer is formed by an inkjet process. These methods can also be utilized when forming a charge-transporting thin film by an inkjet process in the fabrication of electronic devices such as organic photoelectric conversion devices, organic thin-film solar cells, organic perovskite photoelectric conversion devices, organic integrated circuits, organic field-effect transistors, organic thin-film transistors, organic light-emitting transistors, organic optical testers, organic photoreceptors, organic field-quenching devices, light-emitting electrochemical cells, quantum dot light-emitting diodes, quantum lasers, organic laser diodes and organic plasmon light-emitting devices.

### EXAMPLES

Synthesis Examples, Production Examples, Preparation Examples, Comparative Preparation Examples, Working Examples and Comparative Examples are given below to more concretely illustrate the invention, although the invention is not limited by these Examples.

### [Equipment]

Measurements of specimen properties were carried out using the following equipment under the conditions described below.

### (1) Number-average molecular weight (Mn) and weight-average molecular weight (Mw)

Measured as polystyrene-equivalent values by gel permeation chromatography under the following conditions.

| | |
|---|---|
| • Chromatograph: | LC-20AD, a GPC system from Shimadzu Corporation |
| • Columns: | Shodex KF-804L and 803L (Showa Denko K.K.) and TSK-GEL (Tosoh Corporation) were serially connected |
| • Eluant: | Tetrahydrofuran (containing 10 mmol/L of lithium bromide hydrate (LiBr·H₂O)) |
| • Flow rate: | 1 mL/min |
| • Column temperature: | 40°C |

### (2) Inkjet Apparatus and Inkjet Head (application of ink)

| | |
|---|---|
| • Inkjet apparatus: | WaveBuilder (model number: PIJD-1) and inkjetlado, from Cluster Technology Co., Ltd. |
| • Inkjet head: | PIJ-25NSET, from Cluster Technology Co., Ltd. |

### [Reagents]

The meanings of the abbreviations used below are as follows.
- MMA:: Methyl methacrylate
- HEMA:: 2-Hydroxyethyl methacrylate
- HPMA:: 4-Hydroxyphenyl methacrylate
- HPMA-QD:: Compound synthesized by condensation reaction of 1 mole of 4-hydroxyphenyl methacrylate with 1.1 mole of 1,2-naphthoquinone-2-diazide-5-sulfonyl chloride
- CHMI:: N-Cyclohexylmaleimide
- PFHMA:: 2-(Perfluorohexyl)ethyl methacrylate
- MAA:: Methacrylic acid
- AIBN:: α,α'-Azobisisobutyronitrile
- QD1:: Compound synthesized by condensation reaction between 1 mole of α,α,α'-tris(4-hydroxyphenyl)-1-ethyl-4-isopropylbenzene and 1.5 moles of 1,2-naphthoquinone-2-diazide-5-sulfonyl chloride
- GT-401:: Tetra(3,4-epoxycyclohexylmethyl) butanetetracarboxylate-modified ε-caprolactone (product name: Epolead GT-401 (Daicel Corporation))
- PGME: Propylene glycol monomethyl ether
- PGMEA:: Propylene glycol monomethyl ether acetate
- CHN: Cyclohexanone
- TMAH: Tetramethylammonium hydroxide
- TEG:: Triethylene glycol
- TEGDME:: Triethylene glycol dimethyl ether
- DEG:: Diethylene glycol
- 2-PE:: 2-Phenoxyethanol
- BEHP:: Bis(2-ethylhexyl)phthalate

### [1] Fabrication of Substrate with Bank

### (1) Synthesis of Acrylic Polymer

### [Synthesis Example 1]

An acrylic polymer (P1) solution (solids concentration, 40 wt%) was obtained by dissolving 10.0g of MMA, 12.5 g of HEMA, 20.0 g of CHMI, 2.50 g of HPMA, 5.00 g of MAA and 3.20 g of AIBN in 79.8 g of PGME, and reacting for 20 hours at between 60°C and 100°C. The resulting acrylic polymer P1 had a Mn of 3,700 and a Mw of 6,100.

### [Synthesis Example 2]

An acrylic polymer (P2) solution (solids concentration, 20 wt%) was obtained by dissolving 2.50 g of HPMA-QD, 7.84 g of PFHMA, 0.70 g of MAA, 1.46 g of CHMI and 0.33 g of AIBN in 51.3 g of CHN, and reacting for 20 hours at 110°C. The resulting acrylic polymer P2 had a Mn of 4,300 and a Mw of 6,300.

### (2) Production of Positive-Working Photosensitive Resin Composition

### [Production Example 1]

A positive-working photosensitive resin composition was obtained by mixing together 5.04 g of the P1 obtained in Synthesis Example 1, 0.05 g of the P2 obtained in Synthesis Example 2, 0.40 g of QD, 0.09 g of GT-401 and 6.42 g of PGMEA, and stirring for 3 hours at room temperature to give a uniform solution.

### (3) Fabrication of Substrate with Banks

### [Production Example 2]

The positive-working photosensitive resin composition obtained in Production Example 1 was applied with a spin coater onto an ITO-glass substrate that was ozone-cleaned for 10 minutes using the UV-312 from Technovision, Inc. The substrate was then subjected to a pre-bake (120 minutes of heating at a temperature of 100°C) on a hot plate, forming a thin film having a thickness of 1.2 µm. This thin film was irradiated with ultraviolet light (light intensity at 365 nm, 5.5 mW/cm²) for a fixed time using the PLA-600FA UV aligner from Canon Inc. through a patterned mask on which numerous rectangles with 200 µm long sides and 100 µm short sides were written. Next, development was carried out by immersing the thin film for 120 seconds in a 1.0 wt% aqueous TMAH solution, following which the thin film was washed with ultrapure running water for 20 seconds. The thin film on which this rectangular pattern had been formed was then cured by subjecting it to a post-bake (30 minutes of heating at a temperature of 230°), thereby fabricating a substrate with banks thereon.

### [2] Preparation of Organic Function Ink

### [Comparative Preparation Example 1-1] TEG/TEGDME/DEG = 2/68/30 (weight ratio)

An amount of 0.102 g of the oligoaniline compound of formula (c) and 0.202 g of the arylsulfonic acid compound of formula (S1) were added to a mixed solvent of 0.4 g of TEG, 13.6 g of TEGDME and 6 g of DEG, and the system was stirred for 3 hours at 50°C using a hot stirrer. The resulting solution was filtered with a PTFE syringe filter having a pore size of 0.2 µm, giving an organic functional ink.

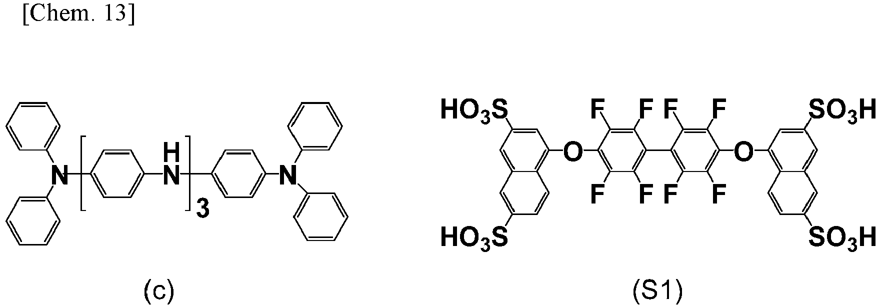

### [Preparation Example 1-1] TEG/TEGDME/DEG = 5/65/30 (weight ratio)

Aside from setting the amount of TEG used to 1 g and the amount of TEGDME used to 13 g, an organic functional ink was obtained in the same way as in Comparative Preparation Example 1-1.

### [Preparation Example 1-2] TEG/TEGDME/DEG = 10/60/30 (weight ratio)

Aside from setting the amount of TEG used to 2 g and the amount of TEGDME used to 12 g, an organic functional ink was obtained in the same way as in Comparative Preparation Example 1-1.

### [Preparation Example 1-3] TEG/TEGDME/DEG = 15/55/30 (weight ratio)

Aside from setting the amount of TEG used to 3 g and the amount of TEGDME used to 11 g, an organic functional ink was obtained in the same way as in Comparative Preparation Example 1-1.

### [Comparative Preparation Example 1-2] TEG/TEGDME/DEG = 20/50/30 (weight ratio)

Aside from setting the amount of TEG used to 4 g and the amount of TEGDME used to 10 g, an organic functional ink was obtained in the same way as in Comparative Preparation Example 1-1.

### [Comparative Preparation Example 1-3] TEG/TEGDME/DEG/2-PE = 2/53/25/20 (weight ratio)

Aside from using 0.4 g of TEG, 10.6 g of TEGDME, 5 g of DEG and 4 g of 2-PE, an organic functional ink was obtained in the same way as in Working Example 1-1.

### [Preparation Example 1-4] TEG/TEGDME/DEG/2-PE = 5/50/25/20 (weight ratio)

Aside from setting the amount of TEG used to 1 g and setting the amount of TEGDME used to 10 g, an organic functional ink was obtained in the same way as in Comparative Preparation Example 1-3.

### [Preparation Example 1-5] TEG/TEGDME/DEG/2-PE = 10/45/25/20 (weight ratio)

Aside from setting the amount of TEG used to 2 g and setting the amount of TEGDME used to 9 g, an organic functional ink was obtained in the same way as in Comparative Preparation Example 1-3.

### [Preparation Example 1-6] TEG/TEGDME/DEG/2-PE = 15/40/25/20 (weight ratio)

Aside from setting the amount of TEG used to 3 g and setting the amount of TEGDME used to 8 g, an organic functional ink was obtained in the same way as in Comparative Preparation Example 1-3.

### [Comparative Preparation Example 1-4] TEG/TEGDME/DEG/2-PE = 20/35/25/20 (weight ratio)

Aside from setting the amount of TEG used to 4 g and setting the amount of TEGDME used to 7 g, an organic functional ink was obtained in the same way as in Comparative Preparation Example 1-3.

### [Comparative Preparation Example 1-5] TEG/TEGDME/DEG/2-PE = 5/50/25/20 (weight ratio)

Aside from using BEHP (boiling point, 385°C) instead of TEG, an organic functional ink was obtained in the same way as in Preparation Example 1-4.

### [3] Fabrication of Substrate with Organic Functional Film

### [Comparative Example 1-1]

The organic functional ink prepared in Comparative Preparation Example 1-1 was discharged using the Inkjet Designer from Cluster Technology Co., Ltd. into the rectangular openings (film-forming regions) on the substrate with banks fabricated in Production Example 2. The resulting applied film was immediately vacuum-dried for 15 minutes at normal temperature under a vacuum of 10 Pa or less, and then dried for 15 minutes at normal pressure and 230°C to form an organic functional film within the banks, thereby giving a substrate with organic functional film. Ink discharge was carried out such that the organic functional film had a thickness near the centers of the openings of 80 nm.

### [Working Examples 1-1 to 1-3, Comparative Examples 1-2]

Aside from using the organic functional inks prepared in Preparation Examples 1-1 to 1-3 and Comparative Preparation Example 1-2 instead of the organic functional ink prepared in Comparative Preparation Example 1-1, an organic functional film was formed in the same way as in Comparative Example 1-1, giving a substrate with organic functional film. Ink discharge was carried out such that the organic functional film had a thickness near the centers of the openings of 80 nm.

### [Working Examples 1-4 to 1-6, Comparative Examples 1-3 and 1-4]

Aside from using the organic functional inks prepared in Preparation Examples 1-4 to 1-6 and Comparative Preparation Examples 1-3 and 1-4, an organic functional film was formed in the same way as in Comparative Example 1-1, giving a substrate with organic functional film. Ink discharge was carried out such that the organic functional film had a thickness near the centers of the openings of 60 nm.

### [Comparative Example 1-5]

Aside from using the organic functional ink prepared in Comparative Preparation Example 1-5 instead of the organic functional ink prepared in Comparative Preparation Example 1-1, an organic functional film was formed in the same way as in Comparative Example 1-1, giving a substrate with organic functional film. However, the organic functional film was highly uneven and had a very poor flatness, making it difficult to calculate the subsequently described pile-up index.

Pile-up indices for the organic functional films formed in the above Working Examples and Comparative Examples were determined. The results are shown in Table 1.

The pile-up index was calculated as B/A× 100 (%), where, as shown in FIG. 1, the bank width is A µm and the range at a film thickness 10% greater than the film thickness at the center of the bank is B µm.

**[Table 1]**

| | Pile-up index (%) |
|---|---|
| Comparative Example 1-1 | 55.4 |
| Working Example 1-1 | 78.7 |
| Working Example 1-2 | 93.6 |
| Working Example 1-3 | 97.1 |
| Comparative Example 1-2 | 56.3 |
| Comparative Example 1-3 | 61.9 |
| Working Example 1-4 | 93.2 |
| Working Example 1-5 | 79.6 |
| Working Example 1-6 | 73.4 |
| Comparative Example 1-4 | 57.2 |

As shown in Table 1, the pile-up index exceeded 70% for all of the organic functional films formed within banks by inkjet application using an organic functional ink containing an ink solvent having a TEG content of 3 to 17 wt%, demonstrating that the pile-up effect by the organic functional ink was effectively suppressed.

## Claims

1. A method for manufacturing a substrate with organic functional film having a substrate, a bank that defines an opening on the substrate and an organic functional film within the bank, which method comprises the steps of:
applying an organic functional ink that includes an organic functional material and a triethylene glycol-containing solvent within the bank by an inkjet process, and
removing the solvent from the organic functional ink applied within the bank by applying a vacuum and thus forming an organic functional film,
wherein the content of triethylene glycol in the solvent is from 3 to 17 wt%.

2. The method for manufacturing a substrate with organic functional film of claim 1, further comprising, following removal of the solvent component by applying a vacuum, the step of heating.

3. The method for manufacturing a substrate with organic functional film of claim 1 or 2, wherein the solvent includes a glycol solvent having a lower boiling point than triethylene glycol.

4. The method for manufacturing a substrate with organic functional film of any one of claims 1 to 3, wherein the solvent includes a glycol ether solvent having a lower boiling point than triethylene glycol.

5. The method for manufacturing a substrate with organic functional film of any one of claims 1 to 4, wherein the solvent includes triethylene glycol, diethylene glycol and triethylene glycol dimethyl ether.

6. The method for manufacturing a substrate with organic functional film of any one of claims 1 to 5, wherein the organic functional material is an aniline derivative.

7. A method for manufacturing an electronic device, which method comprises the step of forming an organic functional layer on the substrate with organic functional film obtained by the method of any one of claims 1 to 6.

8. A pile-up suppressing method which, in the manufacture of a substrate with organic functional film having a substrate, a bank that defines an opening on the substrate and an organic functional film within the bank, suppresses a pile-up effect in the bank by an organic functional ink containing an organic functional material and a solvent when the ink is applied within the bank by an inkjet process;
comprising using as the organic functional ink a solvent having a triethylene glycol content of from 3 to 17 wt%.

9. An inkjet ink that, during the manufacture of a substrate with organic functional film having a substrate, a bank that defines an opening on the substrate and an organic functional film within the bank, is applied within the bank by an inkjet process, which ink comprises an organic functional material and a triethylene glycol-containing solvent, the content of triethylene glycol in the solvent being from 3 to 17 wt%.
